# EUROPEAN PATENT SPECIFICATION

(11) **EP 1 522 097 B1**
(45) Date of publication and mention of the grant of the patent: **16.09.2009**
(21) Application number: 03762850.0
(22) Date of filing: 09.07.2003
(51) Int. Cl.: H01L 21/762

(54) **TRANSFER OF A THIN LAYER FROM A WAFER COMPRISING A BUFFER LAYER**
ÜBERTRAGUNG EINER DÜNNEN SCHICHT VON EINER SCHEIBE MIT EINER PUFFERSCHICHT
TRANSFERT D'UNE COUCHE MINCE DEPUIS UNE TRANCHE COMPRENANT UNE COUCHE TAMPON

(30) Priority: 09.07.2002 FR 0208600
(43) Date of publication of application: 13.04.2005
(73) Proprietor: S.O.I.Tec Silicon on Insulator Technologies, 38190 Bernin (FR)
(72) Inventor: GHYSELEN, Bruno, F-38170 Seyssinet-Pariset (FR); AULNETTE, Cécile, F-38000 Grenoble (FR); OSTERNAUD, Bénédicte, F-38380 Saint Laurent du Pont (FR)
(74) Representative: Le Forestier, Eric
(86) International application number: PCT/IB2003/003497
(87) International publication number: WO 2004/006311

(56) References cited:
- WO-A-01/11930
- WO-A-02/15244
- WO-A-99/52145
- GB-A- 2 365 214
- US-A- 6 059 895
- US-A1- 2002 081 861
- US-B1- 6 323 108
- US-B1- 6 410 371
- HUANG L J ET AL: "SIGE-ON-INSULATOR PREPARED BY WAFER BONDING AND LAYER TRANSFER FOR HIGH-PERFORMANCE FIELD-EFFECT TRANSISTOR" APPLIED PHYSICS LETTERS, AMERICAN INSTITUTE OF PHYSICS. NEW YORK, US, vol. 78, no. 9, 26 February 2001 (2001-02-26), pages 1267-1269, XP001020601 ISSN: 0003-6951

## Description

The present invention relates to a transfer of thin layers from a wafer to a receiving substrate, in order to form structures such as a semiconductor-on-insulator structure, also called an SeOl (Semiconductor-on-insulator) structure.

A first object of a such transfer is usually to produce electronic structures whose active layer, that is to say the layer which comprises or which will comprise the electronic components, is particularly thin and particularly homogeneous through the thickness.

A second object of the transfer can also be to produce these structures by transferring the active layer onto a receiving substrate from a wafer comprising a buffer layer.

A third object of the transfer may be to provide the possibility of reusing part of the wafer, and especially at least part of the buffer layer, for another transfer.

The term "buffer layer" is understood to mean a layer intermediate between two crystallographic structures with different lattice parameters, having in the region of one of its faces a lattice parameter substantially identical to that of the first structure and in the region of its other face a lattice parameter substantially identical to that of the second structure.

Thus, a wafer may, for example, comprise a single-crystal silicon (also called Si) wafer on which a relaxed layer of silicon-germanium (also called SiGe) is produced by means of a buffer layer, despite the difference in lattice parameter existing between these two materials.

By "relaxed layer" it is meant a layer of a semiconductor material, having a crystallographic relaxation rate, as measured by X-ray diffraction or Raman spectroscopy, superior to 50%. A layer having a 100% relaxation rate, has a lattice parameter substantially identical to the nominal lattice parameter of the material of the layer, that is to say the lattice parameter of the material in its bulk form in equilibrium.

Conversely, the term "strained layer" means any layer of a semiconductor material whose crystallographic structure is strained in tension or in compression during crystal growth, such as epitaxy, requiring at least one lattice parameter to be substantially different from the nominal lattice parameter of this material.

Thus, a buffer layer makes it possible to grow an SiGe layer on an Si substrate without this SiGe layer being strained by the substrate.

Given that bulk SiGe is usually not available on the market, the use of a buffer layer in a wafer in order to have a relaxed SiGe layer on the surface thus makes it possible to produce a structure which can thus fulfil the same functions as a bulk SiGe substrate.

The buffer layer inserted between the Si wafer and the relaxed SiGe layer is generally made of SiGe, with a quantitywise proportion of germanium which progressively increases through the thickness of the wafer towards the relaxed layer.

Thus, it makes it possible to:
- gradually increase the germanium content from the wafer towards the relaxed layer;
- confine defects associated with the difference in lattice parameter so that they are buried;
- give a sufficiently thick relaxed SiGe layer stability with respect to a film of different material grown epitaxially on its surface in order to strain the latter so as to modify its lattice parameter without influencing that of the relaxed SiGe layer.

For all these reasons, the buffer layer must be sufficiently thick, typically having a value greater than one micron.

Processes of transferring the layer of relaxed material grown epitaxially on such a buffer layer from the wafer on to a receiving substrate are known.

Such processes are, for example, proposed in an IBM document by L.J. Huang et al. ("SiGe-On-Insulator prepared by wafer bonding and layer transfer for high-performance field-effect transistors", Applied Physics Letters, 26/02/2001, Vol. 78, No. 9) and in document WO 02/33746, in which documents an SGOI (Silicon-Germanium-On-Insulator) structure is produced from a wafer comprising in succession a single-crystal Si support substrate, an SiGe buffer layer and a relaxed SiGe layer.

One process employed in a document by L.J. Huang et al. consists in carrying out a Smart-Cut@ process of the Applicant, known to those skilled in the art, and descriptions of which may be found in a number of works dealing with wafer reduction techniques, in order to remove the relaxed SiGe layer so as to transfer it by means of bonding on to an oxidized receiving substrate, thus producing an SGOI structure.

Despite the advantages that this process affords, a few rough areas may form on the surface of the transferred layer and a surface finishing step then has to be carried out.

This finishing step is generally carried out by means of CMP (chemical-mechanical polishing or chemical-mechanical planarization), which may create surface defects (such as strain-hardened regions), which may imperfectly correct the thickness, and thus retain inhomogeneous layer thicknesses, and which may slow down the transfer of the SiGe layer, and increase its cost.

The process presented in document WO 02/33746 includes, in addition to a CMP polishing step, preliminary lapping, polishing and etching steps in order to remove part of the wafer, thereby slowing down the overall process of removal from the wafer and increasing its cost even further, while not ensuring good homogeneity in layer thickness.

The abovementioned first object of the transfer is therefore not sufficiently achieved in this case.

To try to alleviate this, document US 5 882 987 and US 6 323 108 disclose an overall process for producing SOI (silicon-on-insulator) structures from a wafer comprising in succession a single-crystal Si support substrate, an SiGe layer and an epitaxially grown Si layer bonded to an oxidized receiving substrate.

The Smart-Cut@ technique is employed and causes, after bonding the wafer to a receiving substrate, detachment of part of the wafer at the Si support substrate.

A structure consisting in succession of part of the Si support substrate, the SiGe layer and the epitaxially grown Si layer is thus removed, the whole assembly being bonded to the oxidized receiving substrate.

Two successive selective etching operations are then carried out on the structure in order to remove firstly the remaining part of the Si support substrate with an etching solution such that the SiGe layer forms a stop layer and then in order to remove the SiGe layer with an etching solution such that the Si layer forms a stop layer.

The structure obtained at the end is an SOI structure with a surface Si layer.

Thus, an SeOl structure is obtained with a semiconductor layer which is both thin and uniform through the thickness, substantially identical to the epitaxially grown initial layer, while avoiding the use of a finishing step other than a selective etching operation.

However, the SiGe layer inserted between the Si wafer and the epitaxially grown Si layer has a typical thickness of between 0.01 and 0.2 microns, a thickness which is insufficient, as mentioned above, to pretend to fulfil the role of a buffer layer between the Si wafer and a potential relaxed SiGe layer.

The wafer therefore does not include a buffer layer.

The abovementioned second object of the transfer is therefore not achieved in this case.

In addition, given the order of magnitude of the thickness of the inserted SiGe layer, the structural (strained, relaxed or intermediate) state of the latter does not seem defined with certainty.

Now, another main objective of the transfer relates also to the production of a final structure comprising one or more layers in substantially controlled structural states, such as a substantially relaxed SiGe layer, something which does not seem to be guaranteed in the production of a structure described in the document US 6 323 108.

As regards document WO 01/99169, this provides processes for producing, from a wafer consisting in succession of an Si substrate, an SiGe buffer layer, a relaxed SiGe layer and optionally a strained Si or SiGe layer, a final structure with the relaxed SiGe layer on the optional other strained Si or SiGe layer.

The technique employed for producing such a structure involves, after bonding the wafer to a receiving substrate, removal of the material of the wafer that it is desired not to retain, by selectively etching the Si substrate and the SiGe buffer layer.

Although it transpires that this technique does make it possible to achieve particularly small layer thicknesses which are homogeneous through the thickness, it entails, however, destruction of the Si substrate and the SiGe buffer layer by chemical etching.

These processes therefore do not allow the possibility of reusing part of the wafer, and especially at least part of the buffer layer, for a further transfer of layers.

The third object of the transfer mentioned at the start of the document is therefore not achieved in this case.

WO 02/15244 document describes a source wafer, provided before transfer, comprising relaxed SiGe layer/strained Si/SiGe layer / buffer SiGe layer / Si substrate structure.

Then, the transfer consists doing a Smart-Cut® process at the strained Si layer level.

Implanting ions in the strained layer of Si can be difficult to operate due to the thickness of a such layer, and can thus lead to creation of structural damages inside the SiGe layers surrounding it.

In order in particular to achieve these objectives, the present invention provides, according to a first aspect, a method of producing a structure comprising a thin layer of semiconductor material obtained from a wafer, the wafer comprising a lattice parameter matching layer comprising an upper layer of a material chosen from semiconductor materials having a first lattice parameter, the method comprising the following steps:
(a) growth of a film of a material chosen from semiconductor materials on the upper layer of the matching layer, which film being of material having a nominal lattice parameter substantially different from the first lattice parameter, wherein the grown film has a thickness small enough to keep the first lattice parameter of the upper layer of the underlyed matching layer and thus to be strained;
(b) growth of a relaxed layer of a material chosen from semiconductor materials on the film, the said layer having a nominal lattice parameter substantially identical to the first lattice parameter;
(c) removal of a part of the wafer, characterized by the following operations:
   - formation of an embrittlement zone in the matching layer; and
   - supply of energy in order to detach, at the embrittlement zone level, the part of the wafer comprising the relaxed layer, thus forming the structure to produce.

Further characteristics of the method according to the invention are the following :
- after step (b), an additional step is carried out in which a receiving substrate is bonded to the wafer on the relaxed layer side;
- in this case, the receiving substrate is made of silicon;
- in either of these latter two cases, before bonding, a step of forming at least one bonding layer between the receiving substrate and the wafer is furthermore carried out, the bonding layer being formed on the receiving substrate and/or on the bonding face of the wafer;
- in the latter case, the bonding layer is an electrically insulating material such as silica;
- the embrittlement zone is formed by implantation of species into the matching layer at a depth substantially equal to the implant depth;
- before step (b), the embrittlement zone is formed by porosification of a layer beneath the relaxed layer;
- step (c) comprises, after the energy supply operation of step (c), at least one selective etching operation;
- in one of the latter two cases, a selective etching operation relates to the etching of the remaining part of the matching layer with respect to the film (after detachment of the wafer by energy supply) ;
- it further comprises a growth of a semiconductor material on the film, the semiconductor material is substantially the same as the one of the film (3) ;
- it further comprises an oxidation of the film;
- an annealing treatment is operated at the same time or following the oxidation, this annealing treatment being able to strengthen the bonding interface.
- in the latter case, a selective etching operation relates to the etching of the film with respect to the relaxed layer;
- the process furthermore comprises, after step (c), a step of growing a layer on the relaxed layer;
- in this case, the growth layer on the relaxed layer is made of strained material;
- the matching layer is made of silicon-germanium (the matching layer comprising a buffer layer with a germanium concentration which increases through the thickness and a relaxed layer beneath the film), the film of strained material is made of silicon, the relaxed layer is made of substantially relaxed silicon-germanium (with a germanium concentration substantially equal to the germanium concentration of the relaxed layer of the matching layer);
- in the latter two cases, the growth layer produced on the relaxed layer is made of strained silicon so as to substantially preserve the lattice parameter of the subjacent relaxed silicon-germanium layer;
- the wafer comprises at least one layer furthermore containing carbon with a carbon concentration in the layer substantially less than or equal to 50% ;
- the wafer comprises at least one layer furthermore containing carbon with a carbon concentration in the layer substantially less than or equal to 5%.

According to a second aspect, the invention provides an
- intermediate structure obtained during implantation step of a process according to the invention, comprising in succession a substrate, a lattice parameter matching layer comprising an upper layer having a first lattice parameter, a film of strained material having a nominal lattice parameter substantially different from the first lattice parameter, and a layer made of substantially relaxed material having a nominal lattice parameter substantially identical to the first lattice parameter;

According to a third aspect, the invention provides an application :
- the productions of one of the following "semiconductor on insulator" structures : SGOI, strained Si / SGOI, SiGe / strained Si / SGOI, SiO₂ / SGOI;
- the structure "semiconductor on insulator" comprises a semiconductor layer containing carbon.

Further aspects, objects and advantages of the present invention will become more clearly apparent on reading the following detailed description of the implementation of preferred processes of the invention, these being given by way of non-limiting example and with reference to the appended drawings in which:

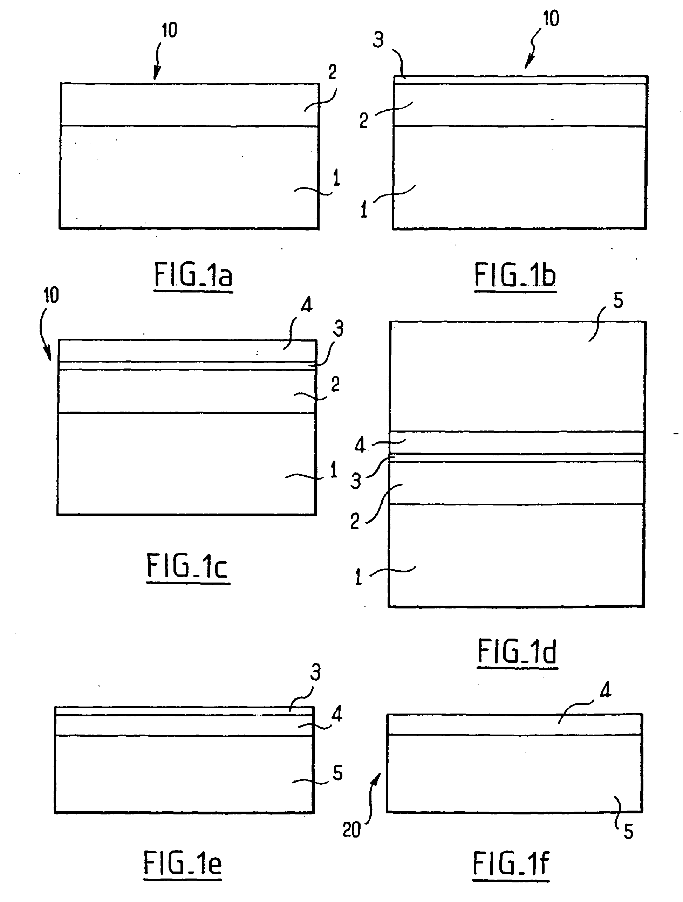

Figure 1 shows the various steps of a method of producing an electronic structure comprising a thin SiGe layer according to the invention.

An example of a method according to the invention will now be described below, which starts, with reference to Figure 1a, from a wafer 10 consisting in the first place of a single-crystal silicon support substrate 1 and an SiGe lattice parameter matching layer 2.

The expression "lattice parameter matching layer" denotes any structure behaving as a buffer layer and having, on the surface, a layer of substantially relaxed material without an appreciable number of structural defects, such as dislocations.

Thus, in our example, it will be advantageous to choose an SiGe matching layer 2 consisting in succession of an SiGe buffer layer and a relaxed SiGe layer on the surface.

The buffer layer preferably has a germanium concentration which grows uniformly from the interface with the support substrate 1, for reasons which were explained above. Its thickness is typically between 1 and 3 micrometers in order to obtain good structural relaxation on the surface.

The relaxed SiGe layer has advantageously been formed by epitaxy on the surface of the buffer layer and its thickness may vary widely depending on the case, with a typical thickness of between 0.5 and 1 micron.

The germanium concentration in the silicon within the relaxed SiGe layer is not limited in terms of value, but is preferably greater than 15% in order to obtain, during the next step (shown by Figure 1 b), a grown strained Si film 3, and is typically between 15% and 30%, but may be greater than 30%.

This 30% limitation represents a typical limitation in the current technique, but this may be caused to change in the coming years.

With reference to Figure 1b, an Si film 3 is grown on the SiGe matching layer 2.

In a first case, the film 3 is grown *in situ*, directly in continuation with the formation of the subjacent matching layer 2, the latter also being in this case advantageously formed by layer growth.

In the second case, the film 3 is grown after a gentle finishing step carried out on the surface of the subjacent matching layer 2, for example by CMP polishing.

The Si film 3 is advantageously formed by epitaxy using techniques such as CVD (chemical vapour deposition) and MBE (molecular beam epitaxy) techniques.

The silicon of the film 3 is then obliged by the matching layer 2 to increase its nominal lattice parameter in order to make it substantially identical to that of its growth substrate and thus introduce internal tensile strains.

It is necessary to form quite a thin Si film 3 - this is because too great a film thickness would cause the strain in the thickness of the film to relax towards the nominal lattice parameter of the silicon and/or defects to be generated in the film 3.

The thickness of the film 3 is thus typically less than 200 angstroms in order to avoid any relaxation of the strain therein.

Referring to Figure 1c, a relaxed SiGe layer 4 is grown on the strained Si film 3, advantageously by epitaxy (for example by CVD or MBE).

This relaxed SiGe layer is produced either *in situ*, immediately after growth of the subjacent film 3, or after a soft finishing step carried out on the surface of the subjacent film 3, such as a CMP polishing step.

The Ge concentration in this layer 4 is substantially the same as that present near the bonding face of the matching layer 2, so as to keep the nominal matching parameter of the relaxed SiGe layer present at this level in the matching layer 2 and preserved in the strained Si film 3.

The thickness of this relaxed SiGe layer 4 may be from a few tens to a few hundreds of nanometres, preferably between 10 and 100 nanometres.

With reference to Figure 1d, a receiving substrate 5 is advantageously bonded to the relaxed SiGe layer 4.

This receiving substrate 5 may, for example, be made of silicon or may consist of other types of materials.

The receiving substrate 5 is bonded by bringing it into intimate contact with the relaxed layer 4, advantageously effecting molecular adhesion (wafer bonding) between the substrate 5 and the layer 4.

This bonding technique, as well as variants, is especially described in the document entitled "Semiconductor Wafer Bonding " (Science and Technology, Interscience Technology) by Q.Y. Tong, U. Gösele and Wiley.

If necessary, bonding is accompanied by an appropriate prior treatment of the respective surfaces to be bonded and/or by supplying thermal energy and/or supplying an additional bonding layer.

Thus, for example, a heat treatment carried out during bonding allows the bonds to be strengthened.

Bonding may also be reinforced by a bonding layer inserted between the layer 4 and the receiving substrate 5, which makes it possible to produce molecular bonds both with the layer 4 and with the material constituting the bonding face of the receiving substrate 5 which are at least as strong as those existing between the layer 4 and the receiving substrate 5.

Thus, silicon oxide (also called silica or SiO₂) is a material that may be chosen for producing such a bonding layer. The silica may be formed on the relaxed layer 4 and/or on the receiving substrate 5, by SiO₂ deposition or by thermal oxidation on the respective bonding surfaces.

Advantageously, the material constituting the bonding face of the receiving substrate 5 and/or the material of the bonding layer optionally formed is electrically insulating, in order in the end to produce an SeOI structure 20, the semiconductor layer of the SeOl structure then being the transferred relaxed layer 4.

Once the receiving substrate 5 has been bonded, part of the wafer 10 is removed in order to transfer the relaxed SiGe layer 4 on the receiving substrate 5 and thus produce the desired structure 20.

Substantially all that part of the wafer 10 on the matching layer 2 side in relation to the relaxed SiGe layer 4 is removed.

With reference to Figures 1e and 1f, this material removal is carried out in two steps:
A first step of material removal, shown in Figure 1e, consists in removing substantially the entire part of the wafer 10 on the matching layer 2 side in relation to the film 3.

To do this, a first material removal operation consists in detachment the donor wafer in a region of the matching layer 2 that has been weakened beforehand in this region.

Two known non-limiting techniques may thus carry out such an operation:
A first technique, called the Smart-Cut@ technique, known to those skilled in the art (and descriptions of which may be found in a number of works dealing with wafer reduction techniques), consists in implanting atom species (such as hydrogen ions) and then in subjecting the implanted region, which then forms an embrittlement zone, to a heat treatment and/or mechanical treatment, or another supply of energy, in order to make the detachment in the embrittlement zone.

Detachment an embrittlement zone thus formed in the matching layer 2 makes it possible to remove most of the wafer 10, in order to obtain a structure comprising the remainder of the matching layer 2, the strained Si film 3, the relaxed SiGe layer 4, the optional bonding layer and the receiving substrate 5.

A second technique consists in obtaining a weak interface by creating at least one porous layer, as described for example in document EP-A-0 849 788, and then in subjecting the weak layer to a mechanical treatment, or another supply of energy, in order to make the detachment in the weakened layer.

This weakened layer made of porous silicon is formed within the support substrate 1, between the support substrate 1 and the matching layer 2, in the matching layer 2 (for example between a buffer layer and a relaxed layer) or on the matching layer 2 (that is to say between the matching layer 2 and the strained Si film 3).

To form a weakened layer within the support substrate 1, the porous layer is advantageously formed on a single-crystal Si wafer and then a second growth is carried out on the porous layer, so as to grow a non-porous Si layer having substantially the same lattice parameter as the Si of the wafer; the support substrate 1 then consists of the wafer, the porous layer and the non-porous Si layer.

A detachment at the weakened layer makes it possible to remove at least some of the wafer 10, in order to obtain a structure comprising the optional remainder of the wafer 10, the strained Si film 3, the relaxed SiGe layer 4, optionally the inserted bonding layer and the receiving substrate 5.

A treatment of the wafer 10, in order to remove the porous silicon which remains after the detachment, is advantageously carried out, such as an etching operation or a heat treatment.

If the porous layer lies within the support substrate 1, a lapping, chemical-mechanical polishing and/or selective chemical etching operations are then advantageously carried out in order to remove the remaining part of the support substrate 1.

These two non-limiting techniques make it possible to rapidly remove, en bloc, a substantial part of the wafer 10.

They also allow the possibility of reusing the removed part of the wafer 10 in another process, such as for example a process according to the invention.

Thus, if the part removed is the support substrate 1, an operation to reform a matching layer 2, a film 3 and a relaxed layer 4 may be carried out as described above, after the surface of the support substrate 1 has been polished.

A second material removal operation after detaching the wafer 10 according, for example, to one of the above two techniques, consists in removing, if necessary, the remaining part of the matching layer 2.

This operation may be carried out by selective chemical etching so that the strained Si film 3 undergoes little or no etching, this forming an etching stop layer.

The remaining part of the matching layer 2 is in this case etched by wet etching using etch solutions having substantial selectivities with respect to the strained Si film 3, such as a solution comprising HF/H₂O₂/CH₃COOH (approximately 1/1000 selectivity) or HNA (hydrofluoric-nitric-acetic solution).

Dry etching operations may also be carried out in order to remove material, such as plasma etching, or by sputtering.

This chemical method has the main advantage of being quite rapid for thin layers to be removed and of avoiding the use of chemical-mechanical polishing finishing operations usually employed after detaching the wafer.

However, the chemical etching operation may advantageously be preceded, especially in the case of a thicker layer to be removed, by mechanical or chemical-mechanical abrasion by lapping and/or chemical-mechanical polishing CMP of the remaining part of the matching layer 2.

These techniques are proposed by way of an example in the present document, but they do not in any way constitute a limitation, the invention covering all types of techniques suitable for removing material from a wafer 10 in accordance with the process according to the invention.

A first application of the invention implies a preservation of the film 3, at least partially, in order to produce a strained Si/SGOI structure.

Optionally, a growth of Si is operating on the film 3 to thicken it.

The obtained strained layer after growth should stay below the critical thickness.

As the last step of etching the remaining part of the matching layer 2 may have damaged or thinned the film 3, an advantage of thickening the film 3, is to get back the initial thickness, or a more important thickness (still below the critical thickness).

This thick strained Si layer can then be used as an active layer (taking thus advantage of electrons high mobility that a such material exhibits).

Optionally, the strained Si of the film 3, thickened or not during the previous option, is at least oxidized.

A first interest of this oxidation step is to encapsulate the underlayer of SiGe, avoiding a Ge diffusion from it.

A second interest is found if an additional annealing step is implemented in order to strengthen the bond at the bonding interface.

Other advantages may be found, as for instance, an improvement of the film 3 quality.

Indeed the bounding annealing step is generally carried out within a range of temperature that can create some defaults in the structure, as for instance pinholes. As describe in WO99/52 145, presence of a SiO₂ layer on a semiconductor layer avoids most of problems during annealing.

Using the Si of film 3 as the material to oxidize is all the more judicious than Si is easier to oxidize than SiGe material.

A second application of the invention implies a removal of the film 3 by a chemical way, as shown in Figure 1f.

To do this, it is preferred to use selective etching employing an etch solution exhibiting high selectivity with respect to the relaxed SiGe layer 4, such as a solution comprising at least one of the following compounds: KOH (potassium hydroxide), NH₄OH (ammonium hydroxide), TMAH (tetramethylammonium hydroxide), EDP (ethylenediamine / pyrocatechol / pyrazine) or HNO₃, or solutions currently under study combining agents such as HNO₃, HNO₂H₂O₂, HF, H₂SO₄, H₂SO₂, CH₃COOH, H₂O₂ and H₂O, as explained in document WO 99/53539, page 9.

This second step makes it possible to retain good surface quality and good thickness homogeneity of the relaxed SiGe layer 4.

Thus, a layer quality substantially identical to that obtained during its growth (shown in Figure 1c) is retained.

This is because this transferred layer 4 has not necessarily been subjected to external mechanical stresses, such as those generated by a CMP finishing step, thus avoiding the appearance of defects associated with such stresses.

However, in certain particular cases, soft polishing is carried out in order to remove any slight surface roughness.

Thus, a final relaxed SiGe-on-substrate structure is obtained, and in particular a relaxed SiGe-on-insulator structure (also called an SGOI structure) if the subjacent material of the relaxed SiGe layer 4 is an electrical insulator.

In one particular application of this structure, any epitaxy may be carried out on the relaxed SiGe layer, such as epitaxy of another SiGe layer or epitaxy of a strained Si layer.

In the latter case, an Si/SGOI final structure would be obtained, the Si layer being strained.

Having completed the final structure, a finishing step may optionally be carried out, such as finishing treatments like, for example, a heat treatment in order to further strengthen the bonding interface with the receiving substrate 5.

The present invention is not limited to an SiGe lattice parameter matching layer 2, but also extends to a constitution of the matching layer 2 from other types of type III-V materials or other materials capable of straining the material of the epitaxially overgrown film 3.

The present invention is not limited to a film 3 of strained Si, but also extends to a constitution of it from other types of III-V materials or other materials capable to be strained by the underlying matching layer 2.

Finally, the present invention does not relate only to transferring a relaxed SiGe layer 4, but in general relates to transferring a layer of any type of semiconductor able to be transferred according to a process of the invention.

In the semiconductor layers, other constituents may be added thereto, such as carbon with a carbon concentration in the layer in question substantially less than or equal to 50% or more particularly with a concentration of less than or equal to 5%.

## Claims

1. Method of producing a structure comprising a thin layer of semiconductor material obtained from a wafer (10), the wafer (10) comprising a lattice parameter matching layer (2) comprising an upper layer of a material chosen from semiconductor materials having a first lattice parameter, the method comprising the following steps :
(a) growth on the upper layer of the matching layer (2) of a film (3) of a material chosen from semiconductor materials, said film (3) being of material having a nominal lattice parameter substantially different from the first lattice parameter, said grown film (3) having a thickness small enough to keep the first lattice parameter of the upper layer of the underlyed matching layer (2) and thus to be strained;
(b) growth of a relaxed layer (4) on the film (3), said relaxed layer (4) being of a material chosen from semiconductor materials having a nominal lattice parameter substantially identical to the first lattice parameter;
(c) removal of a part of the wafer (10) , **characterized by** the following operations:
- formation of an embrittlement zone in the matching layer (2) ; and
- supply of energy in order to detach, at the embrittlement zone level, the part of the wafer (10) comprising the relaxed layer (4), thus forming the structure to produce.

2. Method of producing a structure according to the preceding claim, **characterized in that**, after step (b), an additional step is carried out in which a receiving substrate (5) is bonded to the wafer (10) on the relaxed layer (4) side.

3. Method of producing a structure according to the preceding claim, **characterized in that** the receiving substrate (5) is made of silicon.

4. Method of producing a structure according to either of the preceding two claims, **characterized in that**, before bonding, a step of forming at least one bonding layer between the receiving substrate and the wafer (10) is furthermore carried out, the bonding layer being formed on the receiving substrate (5) and/or on the bonding face of the wafer (10).

5. Method of producing a structure according to the preceding claim, **characterized in that** the bonding layer is an electrically insulating material.

6. Method of producing a structure according to the preceding claim, **characterized in that** the bonding layer is made of silica.

7. Method of producing a structure according to the preceding claim, **characterized in that** the bonding layer is formed by thermal oxidation.

8. Method of producing a structure according to one of the preceding claims, **characterized in that** the embrittlement zone is formed by implantation of species into the matching layer (2) at a depth substantially equal to the implant depth.

9. Method of producing a structure according to one of claims 1 to 7, **characterized in that,** before step (b), the embrittlement zone is formed by porosification of a layer beneath the relaxed layer (4).

10. Method of producing a structure according to one of the preceding claims, **characterized in that** step (c) comprises, after the energy supply operation of step (c), at least one selective etching operation.

11. Method of producing a structure according to the preceding claim, **characterized in that** a selective etching operation relates to the etching of the remaining part of the matching layer (2) with respect to the film (3) (after detachment of the wafer (10) by energy supply).

12. Method of producing a structure according to the preceding claim, **characterized in that** it further comprises a growth of a semiconductor material on the film (3), the semiconductor film being substantially the same as the one of the film (3).

13. Method of producing a structure according to any of the two preceding claims, **characterized in that** it further comprises an oxidation of the film (3).

14. Method of producing a structure according to the preceding claim, **characterized in that** an annealing treatment is operated at the same time or following the oxidation, this annealing treatment being able to strengthen the bonding interface.

15. Method of producing a structure according to the claim 10 or 11, **characterized in that** a selective etching operation relates to the etching of the film (3) with respect to the relaxed layer (4).

16. Method of producing a structure according to one of the preceding claims, **characterized in that** it furthermore comprises, after step (c), a step of growing a layer on the relaxed layer (4).

17. Method of producing a structure according to the preceding claim, **characterized in that** the growth layer on the relaxed layer (4) is made of strained material.

18. Method of producing a structure according to one of the preceding claims, **characterized in that:**
- the matching layer (2) is made of silicon-germanium, the matching layer (2) comprising a buffer layer with a germanium concentration which increases through the thickness and a relaxed layer beneath the film (3);
- the film (3) of strained material is made of silicon;
- the relaxed layer (4) is made of substantially relaxed silicon-germanium, with a germanium concentration substantially equal to the germanium concentration of the relaxed layer of the matching layer (2).

19. Method of producing a structure according to the two preceding claims, **characterized in that** the growth layer produced on the relaxed layer (4) is made of strained silicon so as to substantially preserve the lattice parameter of the subjacent relaxed layer (4).

20. Method of producing a structure according to one of the preceding claims, **characterized in that** the wafer (10) comprises at least one layer furthermore containing carbon with a carbon concentration in the layer substantially less than or equal to 50%.

21. Method of producing a structure according to one of the preceding claims, **characterized in that** the wafer (10) comprises at least one layer furthermore containing carbon with a carbon concentration in the layer substantially less than or equal to 5%.

22. Intermediate structure obtained just after the implementation of the step (c) of the method according to one of claims 2 to 21, comprising in succession a substrate (5), a first layer having a first lattice parameter, a film (3) of strained material, and an upper layer made of substantially relaxed material having a nominal lattice parameter substantially identical to the first lattice parameter, **characterized in that** the free surface of the upper layer exhibits features of post-detachment embrittlement zone surface.

23. Application of the method according to claims 1 to 20, to the productions of one of the following "semiconductor on insulator" structures: SGOI ; strained Si / SGOI, SiGe / strained Si / SGOI ; SiO₂ / SGOI.

24. Application according to the preceding claim, **characterized in that** the structure "semiconductor on insulator" comprises a semiconductor layer containing carbon.

## Patentansprüche

1. Verfahren zum Herstellen einer Struktur, umfassend eine dünne Schicht eines aus einer Scheibe (10) erhaltenen Halbleitermaterials, wobei die Scheibe (10) eine passende Schicht (2) mit gitterartigem Parameter umfasst, umfassend eine obere Schicht aus einem Material, das ausgewählt ist aus Halbleitermaterialien mit einem ersten gitterartigen Parameter, wobei das Verfahren die nachfolgenden Schritte umfasst:
(a) Wachstum auf der oberen Schicht der passenden Schicht (2) eines Films (3) aus einem Material, das ausgewählt ist aus Halbleitermaterialien, wobei der genannte Film (3) aus einem Material mit einem nominalen gitterartigen Parameter besteht, der sich im Wesentlichen vom ersten gitterartigen Parameter unterscheidet, wobei der gewachsene Film (3) eine Dicke aufweist, die gering genug ist um den ersten gitterartigen Parameter der oberen Schicht der darunter liegenden passenden Schicht (2) beizubehalten und somit beaufschlagt ist;
(b) Wachstum einer erschlafften Schicht (4) des Films (3), wobei die genannte erschlaffte Schicht (4) aus einem Material besteht, das ausgewählt ist aus Halbleitermaterialien, mit einem nominalen gitterartigen Parameter, die im Wesentlichen mit dem ersten gitterartigen Parameter identisch ist;
(c) Entfernen eines Teils der Scheibe (10), **gekennzeichnet durch** die nachfolgenden Arbeitsgänge:
- Bilden einer Versprödungszone in der passenden Schicht (2); und
- Zufuhr von Energie zum Ablösen in der Höhenlage der Versprödungszone des Teils der Scheibe (10) umfassend die erschlaffte Schicht (4), wodurch eine Struktur zur Produktion gebildet wird. ,

2. Verfahren zum Herstellen einer Struktur nach vorstehendem Anspruch, **dadurch gekennzeichnet, dass** nach Schritt (b) ein zusätzlicher Schritt ausgeführt wird, bei welchem ein aufnehmendes Substrat (5) mit der Scheibe (10) auf der Seite der erschlafften Schicht (4) verklebt wird.

3. Verfahren zum Herstellen einer Struktur nach vorstehendem Anspruch, **dadurch gekennzeichnet, dass** das aufnehmende Substrat (5) aus Silikon besteht.

4. Verfahren zum Herstellen einer Struktur nach einem der vorstehenden beiden Ansprüche, **dadurch gekennzeichnet, dass** weiterhin vor dem Verkleben ein Schritt zum Bilden wenigstens einer Klebeschicht zwischen dem aufnehmenden Substrat und der Scheibe (10) durchgeführt wird, wobei die Klebeschicht am aufnehmenden Substrat (5) und oder auf der Klebefläche der Scheibe (10) gebildet wird.

5. Verfahren zum Herstellen einer Struktur nach vorstehendem Anspruch, **dadurch gekennzeichnet, dass** die Klebeschicht ein elektrisch isolierendes Mate

6. Verfahren zum Herstellen einer Struktur nach vorstehendem Anspruch, **dadurch gekennzeichnet, dass** die Klebeschicht aus Kieselerde besteht.

7. Verfahren zum Herstellen einer Struktur nach vorstehendem Anspruch, **dadurch gekennzeichnet, dass** die Klebeschicht durch Thermaloxidation gebildet wird.

8. Verfahren zum Herstellen einer Struktur nach einem der vorstehenden Ansprüche, **dadurch gekennzeichnet, dass** die Versprödungszone durch eine Implantation einer Art in die passende Schicht (2) bei einer Tiefe gebildet wird, die im Wesentlichen der Implantattiefe entspricht.

9. Verfahren zum Herstellen einer Struktur nach einem der Ansprüche 1 bis 7, **dadurch gekennzeichnet, dass** vor Schritt (b) die Versprödungszone durch Porosifikation einer Schicht unterhalb der erschlafften Schicht (4) gebildet wird.

10. Verfahren zum Herstellen einer Struktur nach einem der vorstehenden Ansprüche, **dadurch gekennzeichnet, dass** Schritt (c) nach dem Energiezufuhr-Arbeitsgang von Schritt (c) wenigstens einen selektiven Ätzarbeitsgang umfasst.

11. Verfahren zum Herstellen einer Struktur nach vorstehendem Anspruch, **dadurch gekennzeichnet, dass** sich ein selektiver Ätzarbeitsgang auf das Ätzen des verbleibenden Teils der passenden Schicht (2) bezüglich des Films (3) bezieht (nach Ablösen der Scheibe (10) durch die Energiezufuhr).

12. Verfahren zum Herstellen einer Struktur nach vorstehendem Anspruch, **dadurch gekennzeichnet, dass** es ferner ein Wachstum eines Halbleitermaterials auf dem Film (3) umfasst, wobei der Halbleiterfilm im Wesentlich dem auf dem Film (3) entspricht.

13. Verfahren zum Herstellen einer Struktur nach einem der beiden vorstehenden Ansprüche, **dadurch gekennzeichnet, dass** es ferner eine Oxidation des Films (3) umfasst.

14. Verfahren zum Herstellen einer Struktur nach vorstehendem Anspruch, **dadurch gekennzeichnet, dass** eine Härtungsbehandlung zur gleichen zeit oder nach der Oxidation durchgeführt wird, wobei die genannte Härtungsbehandlung die Klebefläche verfestigt.

15. Verfahren zum Herstellen einer Struktur nach Anspruch 10 oder 11, **dadurch gekennzeichnet, dass** sich ein selektiver Ätzarbeitsgang auf das Ätzen des Films (3) bezüglich der erschlafften Schicht (4) bezieht.

16. Verfahren zum Herstellen einer Struktur nach einem der vorstehenden Ansprüche, **dadurch gekennzeichnet, dass** es ferner nach Schritt (c) einen Schritt zum Wachsen einer Schicht auf der erschlafften Schicht (4) umfasst.

17. Verfahren zum Herstellen einer Struktur nach vorstehendem Anspruch, **dadurch gekennzeichnet, dass** die Wachstumsschicht auf der erschlafften Schicht (4) aus einem gespannten Material besteht.

18. Verfahren zum Herstellen einer Struktur nach einem der vorstehenden Ansprüche, **dadurch gekennzeichnet, dass**
- die passende Schicht (2) aus Silikongermanium besteht, wobei die passende Schicht (2) eine Pufferschicht mit einer Germaniumkonzentration umfasst, die sich durch die Dicke hindurch erhöht, und eine erschlaffte Schicht unterhalb des Films (3);
- der Film (3) des gespannten Materials aus Silikon besteht;
- die erschlaffte Schicht (4) aus im Wesentlichen erschlafftem Silikongermanium besteht, wobei eine Germaniumkonzentration im Wesentlichen der Germaniumkonzentration der erschlafften Schicht der passenden Schicht (2) entspricht.

19. Verfahren zum Herstellen einer Struktur nach den beiden vorstehenden Ansprüchen, **dadurch gekennzeichnet, dass** die auf der erschlafften Schicht (4) produzierte Wachstumssicht aus gespanntem Silikon besteht, um den gitterartigen Parameter der darunterliegenden erschlafften Schicht (4) zu konservieren.

20. Verfahren zum Herstellen einer Struktur nach einem der vorstehenden Ansprüche, **dadurch gekennzeichnet, dass** die Scheibe (10) wenigstens eine Schicht umfasst, die ferner Kohlenstoff mit einer Kohlenstoffkonzentration in der Schicht von im Wesentlichen weniger als oder gleich 50% enthält.

21. Verfahren zum Herstellen einer Struktur nach einem der vorstehenden Ansprüche, **dadurch gekennzeichnet, dass** die Scheibe (10) wenigstens eine Schicht umfasst, die ferner Kohlenstoff mit einer Kohlenstoffkonzentration in der Schicht von im Wesentlichen weniger als oder gleich 5% enthält.

22. Zwischenstruktur, die nach Durchführung des Schritts (c) gemäß dem Verfahren nach einem der Ansprüche 2 bis 21 erhalten wird, umfassend der Reihenfolge nach ein Substrat (5), eine erste Schicht mit einem gitterartigen Parameter, einen Film (3) aus gespanntem Material und eine obere Schicht, die aus einem im Wesentlichen erschlafften Material mit einem nominalen gitterartigen Parameter besteht, der im Wesentlichen mit dem ersten gitterartigen Parameter identisch ist, **dadurch gekennzeichnet, dass** die freie Oberfläche der oberen Schicht Merkmale einer Versprödungszonen-Oberfläche nach Ablösung aufweist.

23. Anwendung des Verfahrens nach Anspruch 1 bis 20 bei der Herstellung einer der nachfolgenden "Halbleiter-auf-Isolator"-Strukturen: SGOI ; gespanntes Si / SGOI, SiGe / gespanntes Si / SGOI ; SiO₂ / SGOI.

24. Anwendung nach vorstehendem Anspruch, **dadurch gekennzeichnet, dass** die "Halbleiter-auf-Isolator"-Struktur eine Kohlenstoff enthaltende Halbleiterschicht umfasst.

## Revendications

1. Procédé de production d'une -structure comprenant une couche mince en matériau semi-conducteur obtenue à partir d'une tranche (10), la tranche (10) comprenant une couche de mise en correspondance de paramètre de réseau (2) comprenant une couche supérieure d'un matériau choisi parmi des matériaux semi-conducteurs présentant un premier paramètre de réseau, le procédé comprenant les étapes suivantes :
(a) la croissance sur la couche supérieure de la couche de mise en correspondance (2) d'un film (3) d'un matériau choisi parmi des matériaux semi-conducteurs, ledit film (3) étant constitué d'un matériau présentant un paramètre de réseau nominal sensiblement différent du premier paramètre de réseau, ledit film (3) développé par croissance ayant une épaisseur suffisamment petite pour maintenir le premier paramètre de réseau de la couche supérieure de la couche de mise en correspondance (2) sous-jacente et ainsi être contraint ;
(b) la croissance d'une couche relaxée (4) sur le film (3), ladite couche relaxée (4) étant constituée d'un matériau choisi parmi des matériaux semi-conducteurs présentant un paramètre de réseau nominal sensiblement identique au premier paramètre de réseau ;
(c) le retrait d'une partie de la tranche (10), **caractérisé par** les opérations suivantes :
- la formation d'une zone de fragilisation dans la couche de mise en correspondance (2) ; et
- la fourniture d'énergie pour détacher, au niveau de la zone de fragilisation, la partie de la tranche (10) comprenant la couche relaxée (4) formant ainsi la structure à produire.

2. Procédé de production d'une structure selon la revendication précédente, **caractérisé en ce que,** après l'étape (b), une étape supplémentaire est exécutée dans laquelle un substrat de réception (5) est collé à la tranche (10) sur le côté de la couche relaxée (4).

3. Procédé de production d'une structure selon la revendication précédente**, caractérisé en ce que** le substrat de réception (5) est constitué de silicium.

4. Procédé de production d'une structure selon l'une quelconque des deux revendications précédentes, **caractérisé en ce que**, avant le collage, une étape de formation d'au moins une couche de collage entre le substrat de réception et la tranche (10) est également exécutée, la couche de collage étant formée sur le substrat de réception (5) et/ou sur la face de collage de la tranche (10).

5. Procédé de production d'une structure selon la revendication précédente, **caractérisé en ce que** la couche de collage est un matériau électriquement isolant.

6. Procédé de production d'une structure selon la revendication précédente, **caractérisé en ce que** la couche de collage est constituée de silice.

7. Procédé de production d'une structure selon la revendication précédente, **caractérisé en ce que** la couche de collage est formée par oxydation thermique.

8. Procédé de production d'une structure selon l'une des revendications précédentes, **caractérisé en ce que** la zone de fragilisation est formée par implantation d'une espèce dans la couche de mise en correspondance (2) à une profondeur sensiblement égale à la profondeur d'implant.

9. Procédé de production d'une structure selon l'une des revendications 1 à 7, **caractérisé en ce que,** avant l'étape (b), la zone de fragilisation est formée par porosification d'une couche située sous la couche relaxée (4).

10. Procédé de production d'une structure selon l'une des revendications précédentes, **caractérisé en ce que** l'étape (c) comprend, après l'opération de fourniture d'énergie de l'étape (c), au moins une opération de gravure sélective.

11. Procédé de production d'une structure selon la revendication précédente, **caractérisé en ce qu'**une opération de gravure sélective concerne la gravure de la partie restante de la couche de mise en correspondance (2) par rapport au film (3) (après détachement de la tranche (10) par fourniture d'énergie).

12. Procédé de production d'une structure selon la revendication précédente, **caractérisé en ce qu'**il comprend en outre la croissance d'un matériau semi-conducteur sur le film (3), le film semi-conducteur étant sensiblement identique au film (3).

13. Procédé de production d'une structure selon l'une quelconque des deux revendications précédentes, **caractérisé en ce qu'**il comprend en outre l'oxydation du film (3).

14. Procédé de production d'une structure selon la revendication précédente, **caractérisé en ce qu'**un traitement de recuit est opéré en même temps que l'oxydation ou après celle-ci, le traitement de recuit étant capable de renforcer l'interface de collage.

15. Procédé de production d'une structure selon la revendication 10 ou 11, **caractérisé en ce qu'**une opération de gravure sélective concerne la gravure du film (3) par rapport à la couche relaxée (4).

16. Procédé de production d'une structure selon l'une des revendications précédentes, **caractérisé en ce qu'**il comprend en outre, après l'étape (c), une étape de croissance d'une couche sur la couche relaxée (4).

17. Procédé de production d'une structure selon la revendication précédente, **caractérisé en ce que** la couche de croissance sur la couche relaxée (4) est constituée d'un matériau contraint.

18. Procédé de production d'une structure selon l'une des revendications précédentes, **caractérisé en ce que :**
- la couche de correspondance (2) est constituée de silicium-germanium, la couche de mise en correspondance (2) comprenant une couche tampon avec une concentration en germanium qui augmente à travers l'épaisseur et une couche relaxée sous le film (3) ;
- le film (3) en matériau contraint est constitué de silicium ;
- la couche relaxée (4) est constituée de silicium-germanium sensiblement relaxé, avec une concentration en germanium sensiblement égale à la concentration en germanium de la couche relaxée de la couche de mise en correspondance (2).

19. Procédé de production d'une structure selon les deux revendications précédentes, **caractérisé en ce que** la couche de croissance produite sur la couche relaxée (4) est constituée de silicium déformé de manière à préserver sensiblement le paramètre de réseau de la couche relaxée (4) sous-jacente.

20. Procédé de production d'une structure selon l'une des revendications précédentes, **caractérisé en ce que** la tranche (10) comprend au moins une couche supplémentaire contenant du carbone avec une concentration en carbone dans la couche sensiblement inférieure ou égale à 50 %.

21. Procédé de production d'une structure selon l'une des revendications précédentes, **caractérisé en ce que** la tranche (10) comprend au moins une couche supplémentaire contenant du carbone avec une concentration en carbone dans la couche sensiblement inférieure ou égale à 5 %.

22. Structure intermédiaire obtenue juste après la mise en oeuvre de l'étape (c) du procédé selon l'une des revendications 2 à 21, comprenant successivement un substrat (5), une première couche présentant un premier paramètre de réseau, un film (3) constitué d'un matériau contraint et une couche supérieure constituée d'un matériau sensiblement relaxé présentant un paramètre de réseau nominal sensiblement identique au premier paramètre de réseau, **caractérisée en ce que** la surface libre de la couche supérieure présente les caractéristiques d'une surface de zone de fragilisation après détachement.

23. Application du procédé selon les revendications 1 à 20, aux productions de l'une des structures « semi-conducteur sur isolant » suivantes : SGOI ; Si contraint/SGOI, SiGe/Si contraint/SGOI ; SiO₂/SGOI.

24. Application selon la revendication précédente, **caractérisée en ce que** la structure « semi-conducteur sur isolant » comprend une couche de semi-conducteur contenant du carbone.
